# EUROPÄISCHE PATENTSCHRIFT

(11) **EP 0 485 830 B1**
(45) Veröffentlichungstag und Bekanntmachung des Hinweises auf die Patenterteilung: **27.03.1996**
(21) Anmeldenummer: 91118708.6
(22) Anmeldetag: 02.11.1991
(51) Int. Cl.: H01L 21/324, H01L 21/18, H01L 21/265, H01L 21/331

(54) **Verfahren zur Rekristallisierung voramorphisierter Halbleiteroberflächenzonen**
Process for the recrystallization of a pre-amorphized superficial zone of a semi-conductor
Procédé de recristallisatiné d'une zone superficielle pré-amorphizée le semi-conducteur

(30) Priorität: 10.11.1990 DE 4035842
(43) Veröffentlichungstag der Anmeldung: 20.05.1992
(73) Patentinhaber: TEMIC TELEFUNKEN microelectronic GmbH, D-74072 Heilbronn (DE)
(72) Erfinder: Hefner, Heinz-Achim, W-7129 Brackenheim (DE); Imschweiler, Joachim, W-7100 Heilbronn-Böckingen (DE); Seibt, Michael, Dr., W-3400 Göttingen (DE)
(74) Vertreter: Maute, Hans-Jürgen, Dipl.-Ing.

(56) Entgegenhaltungen:
- WO-A-86/03334
- PROCEEDINGS OF THE 1990 BIPOLAR CIRCUITS AND TECHNOLOGY MEETING, MINNEAPOLIS, USA, SEPTEMBER 17-18, 1990 Seiten 162 - 165; EHINGER ET AL: 'Progress in speed power performance of bipolar technology by sub-10 KeV B implantation into amorphized Si'
- APPLIED PHYSICS A. SOLIDS AND SURFACES. Bd. A47, Nr. 2, Oktober 1988,
- HEIDELBERG DE Seiten 147 - 155; WURM ET AL: 'Modulated optical reflectance measurements on amorphous silicon layers and detection of residual defects'
- APPLIED PHYSICS LETTERS. Bd. 52, Nr. 12, 21. März 1988, NEW YORK US Seiten 963 - 965; OZTURK ET AL: 'Very shallow p+-n junction formation by low-energy BF2+ ion implantation into crystalline and germanium preamorphized silicon'

## Beschreibung

Die Erfindung betrifft ein Verfahren zur Herstellung von flachen Übergängen in Silizium durch Implantation von Silizium- oder Germanium-Ionen zur Amorphisierung einer Oberflächenzone, anschließende Dotierung dieser Oberflächenzone und abschließende Rückkristallisation der Oberflächenzone durch eine Wärmebehandlung. Des weiteren betrifft die Erfindung ein Halbleiterbauelement, das einen solchen flachen Übergang enthält.

Zur Herstellung flacher pn-Übergänge in Silizium werden auch Verfahren angewandt, bei denen Oberflächenzonen von einkristallinem Silizium durch Implantation von Silizium- oder Germanium-Ionen in einen amorphen Zustand gebracht werden. In eine auf diese Weise vorbehandelte Zone implantierte Dotierungsstoffe wie B, BF₂ ⁺, P oder As sind bezüglich Eindringtiefe, anomaler (beschleunigter) Diffusion und Kanalbildung sehr stark eingeschränkt. Es entsteht ein steiles Dotierungsprofil. Bei der Rekristallisierung der amorphen Oberflächenzone durch Festphasenepitaxiewachstum muß bei der Temperaturwahl darauf geachtet werden, daß die Dotierungsstoffe nicht zu sehr diffundieren, damit das Dotierungsprofil erhalten bleibt.

In "J. Appl. Phys. 54, No. 12, December 1983, S. 6879 - 6889", wird ein Verfahren beschrieben, bei dem die Rekristallisation bei einer Temperatur von 925 °C für eine Zeitdauer von 20 min stattfindet.

In der EP 0 201 585 A1 (= WO-A-86/03334) wird ein Zwei-Stufenprozeß zur Rekristallisierung einer amorphen Oberflächenzone angegeben, bei der die Halbleiterprobe zunächst für ca. 30 min auf 600 °C gehalten wird, wobei die amorphe Schicht durch Festphasenepitaxie (SPE) rekristallisiert, und anschließend innerhalb einer Sekunde auf über 1000 °C erhitzt wird, wodurch die implantierten Dotierungsstoffe aktiviert werden.

Beide bekannten Verfahren haben den Nachteil, daß sich im rekristallisierten Zustand an der Stelle, an der sich der Übergangsbereich von amorphem zu kristallinem Material befunden hat, Fehler in der Kristallstruktur vorfinden. Bei diesen Fehlern handelt es sich in erster Linie um Stapel- und Versetzungsfehler, die die elektrischen Eigenschaften des Übergangs stark beeinträchtigen.

Aus Appl. Phys. Lett. 52 (12), 21.03.1988, Seiten 963 - 965 ist ein Verfahren zum Herstellen von flachen p⁺-n Übergängen durch niederenergetisches Implantieren von BF₂ ⁺-Ionen in durch Germanium voramorphisiertes Silizium bekannt, bei dem der Kristall zunächst durch Festphasenepitaxie bei 600°C und einer Dauer von 30 min in einem Ofen unter Stickstoffatmosphäre wiederhergestellt wird. Anschließend wird bei drei unterschiedlichen Temperaturen von 950, 1000 und 1050 °C für eine Dauer von jeweils 10 sec ein Kurzzeit-Ausheilschritt (RTA) durchgeführt. Die Autoren kommen zu dem Ergebnis, daß bei RTA-Temperaturen über 950 °C die Bor-Diffusion die Tiefe des pn-Übergangs bestimmt und daß die Voramorphisierung des Silizium-Kristalls durch Germanium für höhere RTA-Temperaturen keine Vorteile in bezug auf die Tiefe des Übergangs gegenüber der Implantierung in den Kristall bringt.

Aus "IEEE 1990 Bipolar Circuits and Technology Meeting 7.3, S. 162 - 165" ist ein Verfahren bekannt, bei dem vor der Rekristallisation der Übergangsbereich zwischen amorpher Oberflächenzone und kristallinem Basismaterial in einem Temperaturprozeß bei 450 °C für eine Zeitdauer von 30 min geglättet wird. Bei einem sich anschließenden Kurzzeitausheilungsprozeß (RTA) bei 1075 °C und 10 sec rekristallisiert die Oberflächenzone und gleichzeitig werden die Dotierstoffe aktiviert. Nach Anwendung dieses bekannten Verfahrens konnten zwar keine Fehler mehr nachgewiesen werden, die ihren Ursprung in dem Übergangsbereich haben, dafür muß aber aufgrund der hohen RTA-Temperatur eine verstärkte Bor-Diffusion in Kauf genommen werden.

Der Erfindung liegt die Aufgabe zugrunde, ein Verfahren zur Herstellung von flachen Übergängen (≤ 0,1 Mikrometer) in Silizium anzugeben, bei der die fehlerfreie Rekristallisation der amorphen Oberflächenschicht gewährleistet wird.

Diese Aufgabe wird durch ein Verfahren nach den Merkmalen des Anspruchs 1 gelöst. Die weitere vorteilhafte Ausgestaltung der Erfindung ergibt sich aus den Unteransprüchen.

Die Erfindung wird im folgenden anhand eines Ausführungsbeispiels erläutert.

Zur Herstellung eines flachen Übergangs in Silizium wird zunächst eine amorphe Oberflächenschicht auf einem einkristallinen Grundkörper durch Implantation von Ionen erzeugt. Dabei wird eine Mischung von GeH₄/H₂ als Ionenquelle benutzt, wobei ⁷⁰Ge- oder ⁷⁴Ge-Isotope zur Amorphisierung verwendet werden. Die Implantationsenergien liegen im Bereich von 50 keV - 150 keV bei Ionendosen von 2 · 10¹⁴ cm⁻ - 9 · 10¹⁴ cm⁻. Als besonders vorteilhaft hat sich eine Energie von ca. 70 keV bei einer Ionendosis von 3 - 5 · 10¹⁴ cm⁻ herausgestellt.

So ergibt beispielsweise eine Implantation von 70 keV Ge-Ionen bei einer Dosis von 3 · 10¹⁴ cm⁻ eine amorphe Schicht von ca. 85 nm Dicke. Zum Grundkörper hin schließt sich ein Übergangsbereich mit einer Dicke von ca. 15 nm an, in dem die Grenzfläche zwischen der amorphen Schicht und dem kristallinen Material des Grundkörpers sehr rauh ist und in dem kristalline bzw. amorphe Inseln im Gebiet der jeweils entgegengesetzten Struktur existieren. Die rauhe Übergangszone mit ihren Inseln stellt Keime für die Bildung von Gitterdefekten, insbesondere Stapelfehler und Versetzungen, bei der späteren Rekristallisation dar.

Im nächsten Verfahrensschritt wird die amorphe Oberflächenschicht durch Implantation von B-, BF₂ ⁺-, P- oder As-Ionen dotiert. In der amorphen Schicht sind anomale Diffusion und Kanalbildungseffekte der implantierten Ionen in idealer Weise unterdrückt. Durch die Wahl der Ionenenergien kann ein gewünschtes Dotierungsprofil eingestellt werden. Implantationsenergien von 25 keV bei einer Dosis von 2 · 10¹⁴ cm⁻ haben sich im Falle von BF₂ ⁺-Ionen und Ge-Voramorphisierung bei ca. 70 keV bewährt.

Der Rekristallisation der amorphen Schicht geht ein weiterer Verfahrensschritt voraus, der eine Glättung der rauhen Übergangszone bewirkt. Dazu wird die Halbleiterprobe ca. 30 - 50 min in einem Ofen bei einer Temperatur von ca. 400 - 460 °C in einer Stickstoffatmosphäre vorbehandelt. Bei dieser Temperatur findet noch keine Umwandlung der amorphen Schicht statt, die fraktale Übergangszone wird aber bereits geglättet, wobei sich insbesondere die amorphen und kristallinen Inseln zurückbilden.

Bei der anschließenden Wärmebehandlung bei einer Temperatur von 500 - 600 °C für eine Zeitdauer von 30 - 50 min rekristallisiert die amorphe Schicht durch festphasenepitaktisches Wachstum auf den Basiskristall des Substrats. Da die rauhe Übergangszone vor der eigentlichen Rekristallisation geglättet wurde, sind nach dem epitaktischen Wachstum keine Stapel- und Versetzungsfehler in der zuvor amorphen Schicht nachzuweisen. Insbesondere hat sich für die Festphasenepitaxie eine Temperatur von 550 °C bei einer Zeitdauer von 40 min in einer Stickstoffatmosphäre als besonders vorteilhaft erwiesen.

Die abschließende Kurzzeiterhitzung aktiviert die Dotierungsatome bei einer Temperatur von 1000 °C - 1100 °C, ohne daß sich das Dotierungsprofil während der kurzen Zeitdauer von 5 - 10 sec wesentlich verbreitern kann. Da die eigentliche Rekristallisierung bei einer Temperatur von 600 °C stattgefunden hat und nun lediglich die Dotierung aktiviert wird, entstehen in diesem Verfahrensschritt keine zusätzlichen Fehler im Kristallaufbau.

Ein Beispiel für einen typischen Anwendungsfall eines oben beschriebenen flachen Übergangs ist ein bipolarer Hochfrequenztransistor. Aber auch in anderen Bauelementen wie z. B. Dioden kann ein solcher flacher Übergang vorteilhaft angewandt werden.

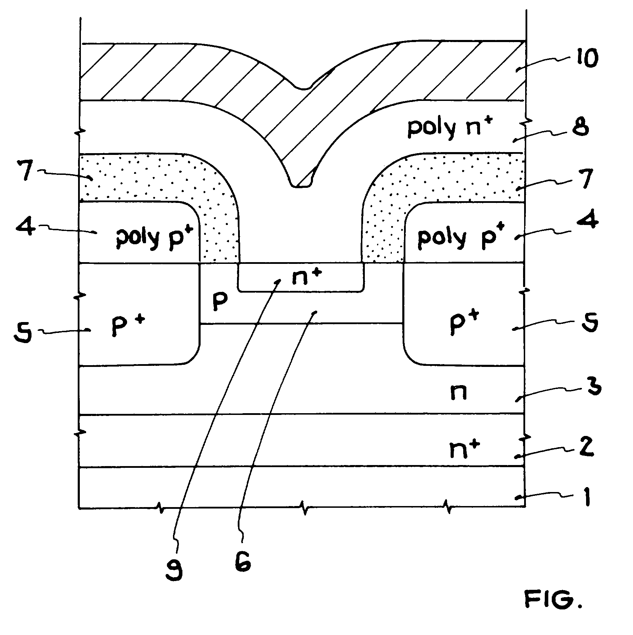

Die Figur zeigt einen Querschnitt durch einen Transistor, dessen Basiszone 6 nach dem erfindungsgemäßen Verfahren hergestellt wurde. Im folgenden sei anhand der Figur der Aufbau eines solchen Transistors erläutert. Auf einem Halbleitersubstrat 1 werden nach bekannten Verfahren zunächst der vergrabene Kollektoranschluß 2 und der Kollektor 3 hergestellt. Die p⁺-dotierte Polysiliziumschicht 4 dient als Basisanschluß und als Quelle zum Eindiffundieren der extrinsischen Basis 5. Nach weiteren Maskierungsschritten wird die intrinsische Basisregion 6 durch Implantation von Germanium amorphisiert. Die Energie der Germanium-Ionen beträgt dabei 70 keV. Es wird eine Dosis von 2 · 10¹⁴ cm⁻ implantiert. Anschließend wird die zuvor amorphisierte Zone durch Implantation von BF₂ ⁺-Ionen mit einer Energie von 25 keV und einer Dosis von 3 · 10¹⁴ cm⁻ dotiert. Da in amorphes Material implantiert wird, entspricht das Dotierungsprofil einer idealen Verteilung. Kanalbildung und anomale Diffusion der implantierten Ionen sind stark reduziert. Nun wird die amorphisierte Schicht in einem Ofenprozeß rekristallisiert. Im ersten Prozeßschritt wird bei 450 °C der Übergangsbereich zwischen der amorphen Schicht und dem kristallinen Basiskristall geglättet. Eine Rekristallisation der amorphen Schicht findet bei diesem Prozeßschritt noch nicht statt, da die Temperatur für festphasenepitaktisches Wachstum nicht genügend hoch ist. Nach ca. 40 min wird die Temperatur im Ofen auf 550 °C erhöht. In diesem zweiten Prozeßschritt rekristallisiert die amorphe Schicht innerhalb von 40 min nahezu fehlerfrei, da die Fehlerkeime im Übergangsbereich im vorausgegangenen Prozeßschritt entfernt worden sind. Bevor nun mittels einer Kurzzeiterhitzung die Dotierungsstoffe aktiviert werden, wird nach bekannten Verfahren das Polysilizium 8 aufgebracht und anschließend durch As-Implantation dotiert. Diese Polysiliziumschicht 8 hat zwei Funktionen. Zum einen dient sie als Emitteranschluß und zum anderen wirkt sie als Quelle für das Eindiffundieren des Emitters 9. Nun folgt der dritte Teil der erfindungsgemäßen Wärmebehandlung. Durch eine Kurzzeiterhitzung auf 1000 - 1200 °C werden nun die Dotierungsstoffe der Basiszone 6 aktiviert und gleichzeitig wird die Emitterzone 9 eindiffundiert. Durch Variation der Zeitdauer der Kurzzeiterhitzung im Bereich von 5 - 30 sec kann außerdem die Basisweite des Transistors eingestellt werden. Abschließend werden Oberflächenpassivierung und Metallisierung 10 durch bekannte Verfahren realisiert.

Mit auf diese Weise produzierten Transistoren werden Grenzfrequenzen von ca. 30 GHz erreicht.

## Patentansprüche

1. Verfahren zum Herstellen einer Halbleiteranordnung aus Silizium mit einer Oberflächenzone geringer Eindringtiefe, zu deren Herstellung in die Oberfläche eines einkristallinen Halbleiterkörpers die Oberflächenzone amorphisierende Ionen der vierten Hauptgruppe implantiert werden, danach die Oberflächenzone mittels implantierter Störstellen dotiert wird und schließlich die amorphe Schicht durch eine Wärmebehandlung rekristallisiert wird,
. wobei die Wärmebehandlung aus einem ersten Ofenprozeßschritt besteht, der bei einer Temperatur von 400 - 460 °C 30 - 50 min andauert, wobei noch keine Rekristallisation der amorphen Schicht stattfindet, aber bereits eine Glättung des Übergangsbereichs zwischen der amorphen Oberflächenzone und dem einkristallinen Halbleiterkörper erfolgt,
. dem sich ein zweiter Ofenprozeßschritt anschließt, der bei einer Temperatur von 500 - 600 °C 30 - 50 min andauert und dessen Temperatur damit genügend hoch ist, damit die amorphe Oberflächenzone rekristallisiert und genügend niedrig ist, damit die Beweglichkeit der implantierten Störstellenatome klein bleibt,
. dem eine abschließende Kurzzeiterhitzung folgt, die bei einer Temperatur von 1000 - 1200 °C 5 - 30 sec andauert und deren Temperatur damit ausreichend hoch ist, um die implantierten Störstellenatome zu aktivieren und die Zeitdauer damit genügend kurz ist, um die Umverteilung der Störstellen klein zu halten.

2. Verfahren nach Anspruch 1, dadurch gekennzeichnet, daß die Oberflächenzone durch Implantation von Germanium- oder Silizium-Ionen amorphisiert wird.

3. Verfahren nach Anspruch 1 oder 2, dadurch gekennzeichnet, daß die Oberflächenzone durch Implantationen von Germanium-Ionen bei einer Energie von ca. 70 keV und einer Dosis von ca. 3 · 10¹⁴ cm⁻ amorphisiert wird.

4. Verfahren nach einem der Ansprüche bis 3, dadurch gekennzeichnet, daß die Oberflächenzone durch Implantation von B, BF₂ ⁺, P oder As dotiert wird.

5. Verfahren nach einem der Ansprüche 1 bis 4, dadurch gekennzeichnet, daß die Oberflächenzone durch BF₂ ⁺-lmplantation bei einer Energie von 15 keV - 25 keV und einer Dosis von 3 · 10¹³ cm⁻ - 3 · 10¹⁴ cm⁻ dotiert wird.

6. Verwendung des Verfahrens nach einem der vorangegangenen Ansprüche zur Herstellung der Basiszone eines bipolaren Hochfrequenztransistors.

## Claims

1. Method for producing a semiconductor arrangement of silicon with a surface region of a small penetration depth, the production of which is carried out by implanting ions of the fourth main group in the surface of a single-crystal semiconductor body, which ions make the surface region amorphous, then doping the surface region by means of implanted impurities and, finally, recrystallising the amorphous layer by a heat treatment,
- wherein the heat treatment consists of a first furnace process step which continues at a temperature of 400 - 460°C for 30 - 50 minutes, during which time no recrystallisation of the amorphous layer yet takes place, although the transition region between the amorphous surface region and the single-crystal semiconductor body is already smoothed,
- which step is followed by a second furnace process step which continues at a temperature of 500 - 600°C for 30 to 50 minutes and the temperature of which is thus sufficiently high for the amorphous surface region to recrystallise and sufficiently low to maintain a low level of mobility of the implanted impurity atoms,
- which step is followed by a final short-time heating step which is continued at a temperature of 1000 - 1200°C for 5 - 30 seconds, the temperature of which is sufficiently high to activate the implanted impurity atoms and the duration of which is thus sufficiently short to maintain a low level of redistribution of the impurities.

2. Method according to claim 1, characterised in that the surface region is made amorphous by implanting germanium or silicon ions.

3. Method according to claim 1 or 2, characterised in that the surface region is made amorphous by implanting germanium ions with an energy of approximately 70 keV and a dose of approximately 3·10¹⁴cm⁻.

4. Method according to any one of claims 1 to 3, characterised in that the surface region is doped by implanting B, BF₂ ⁺, P or As.

5. Method according to any one of claims 1 to 4, characterised in that the surface region is doped by implanting BF₂ ⁺ with an energy of 15 keV - 25 keV and a dose of 3·10¹³cm⁻-3·10¹⁴cm⁻.

6. Use of the method according to any one of the preceding claims for producing the base region of a high-frequency transistor.

## Revendications

1. Procédé pour réaliser un dispositif semi-conducteur au silicium ayant une zone superficielle de faible profondeur de pénétration, pour la réalisation duquel on implante dans la surface d'un corps semi-conducteur monocristallin des ions du quatrième groupe principal rendant la zone superficielle amorphe, on dope ensuite la zone superficielle au moyen de zones de perturbation implantées et on recristallise enfin la couche amorphe par un traitement thermique, procédé
. selon lequel le traitement thermique comprend une première étape de processus au four, s'effectuant à une température de 400 - 460 °C pendant 30 - 50 min, au cours de laquelle une recristallisation de la couche amorphe ne se produit pas encore, mais la région de transition entre la zone superficielle amorphe et le corps semi-conducteur monocristallin est lissée, étape
. à laquelle se raccorde une deuxième étape de processus au four, s'effectuant à une température de 500 - 600 °C pendant 30 - 50 min et dont la température est ainsi suffisamment élevée pour que la zone superficielle amorphe recristallise et suffisamment basse pour que la mobilité des atomes implantés des zones de perturbation reste faible, deuxième étape
. qui est elle-même suivie, pour terminer, d'un échauffement de courte durée, s'effectuant à une température de 1000 - 1200 °C pendant 5 - 30 s et dont la température est ainsi suffisamment élevée pour activer les atomes implantés des zones de perturbation et la durée est ainsi suffisamment courte pour maintenir la redistribution des zones de perturbation faible.

2. Procédé selon la revendication 1, caractérisé en ce que l'on rend la zone superficielle amorphe par implantation d'ions de germanium ou de silicium.

3. Procédé selon la revendication 1 ou 2, caractérisé en ce que l'on rend la zone superficielle amorphe par des implantations d'ions de germanium à une énergie d'environ 70 keV et une dose d'environ 3·10¹⁴ cm⁻.

4. Procédé selon une des revendications 1 à 3, caractérisé en ce que l'on dope la zone superficielle par implantation de B, BF₂ ⁺, P ou As.

5. Procédé selon une des revendications 1 à 4, caractérisé en ce que l'on dope la zone superficielle par implantation de BF₂ ⁺ à une énergie de 15 keV - 25 keV et une dose de 3·10¹³ cm⁻ à 3·10¹⁴cm⁻.

6. Application du procédé selon une des revendications précédentes pour réaliser la zone de base d'un transistor bipolaire pour hautes fréquences.
